(19) **Europäisches Patentamt / European Patent Office / Office européen des brevets**

(11) **EP 4 763 477 A1**

(12) # EUROPEAN PATENT APPLICATION
published in accordance with Art. 153(4) EPC

(43) Date of publication:
24.06.2026 Bulletin 2026/26

(21) Application number: 24854231.8

(22) Date of filing: 15.08.2024

(51) International Patent Classification (IPC):
*B29C 59/02* (2006.01)          *B29C 33/42* (2006.01)
*G02B 5/18* (2006.01)          *G02B 6/13* (2006.01)
*G02B 6/124* (2006.01)

(52) Cooperative Patent Classification (CPC):
B29C 33/42; B29C 59/02; G02B 5/18; G02B 6/124;
G02B 6/13

(86) International application number:
PCT/JP2024/029129

(87) International publication number:
WO 2025/037643 (20.02.2025 Gazette 2025/08)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 16.08.2023 JP 2023132729

(71) Applicant: Scivax Corporation
Kawasaki-shi, Kanagawa 212-0032 (JP)

(72) Inventors:
• AWAYA, Nobuyoshi
  Kawasaki-shi
  Kanagawa 212-0032 (JP)
• TANAKA, Satoru
  Kawasaki-shi
  Kanagawa 212-0032 (JP)

(74) Representative: Gille Hrabal
Partnerschaftsgesellschaft mbB
Patentanwälte
Brucknerstraße 20
40593 Düsseldorf (DE)

(54) **OPTICAL WAVEGUIDE MOLD, METHOD FOR MANUFACTURING OPTICAL WAVEGUIDE, AND OPTICAL WAVEGUIDE**

(57)    An optical waveguide which has a suppressed undulation at an optical transmit portion, and also has a suppressed residual film at an optical input portion and at an optical output portion, an optical waveguide mold to manufacture the optical waveguide, and a method for manufacturing the optical waveguide are provided. An optical waveguide mold is to manufacture an optical waveguide which is formed of a transparent substrate 4 and of a resin 5, and which includes an optical transmit portion 1, an optical input portion 2, and an optical output portion 3. This mold includes a flat optical-transmit-portion pattern 61 to form the optical transmit portion 1 on the resin 5, and either one of or both of an optical-input-portion pattern 62 to form the optical input portion 2 and an optical-output-portion pattern 63 to form the optical output portion 3. When it is defined that a depth of the recess of the optical-input-portion pattern 62 or of the optical-output-portion pattern 63 is B, a fill factor of the convexity thereof is FF, and a difference between the height of the optical-input-portion pattern 62 or of the optical-output-portion pattern 63 and the height of the optical-transmit-portion pattern 61 is D, the following equation is satisfied: $0.9 \times B \times (1 - FF) \leq D \leq 1.1 \times B \times (1 - FF)$.

EP 4 763 477 A1

FIG. 8

（a）

62(63)   6   61

B   P   D

5
4

（b）

62(63)   6   61

5
4

（c）

62(63)   6   61

5
4

（d）

62(63)   6   61

p   2 (3)   1   5   t

b
d   51   4

8

**Description**

TECHNICAL FIELD

The present disclosure relates to an optical waveguide mold, a method for manufacturing an optical waveguide, and the optical waveguide.

BACKGROUND ART

As for a glass Waveguide for Augmented Reality (AR) that has a large market prospected, developments are actively made for a resin material with a high refractive index in order to obtain a high viewing angle performance, and for various input and output coupler structures in order to accomplish a high transmit rate for an image and also uniform output thereof. Optical waveguides are lightweight and can transmit a signal at fast speed, thus utilized in various electronic devices. As for such optical waveguides, in recent years, a pattern formation technology by imprinting is getting attention in substitution for a photo-lithography technology (e.g., Patent Document 1).

CITATION LIST

PATENT LITERATURES

Patent Document 1: JP2016-207717A

SUMMARY OF INVENTION

TECHNICAL PROBLEM

When, however, it is attempted to create an optical waveguide by imprinting, if a void of the optical-transmit-portion pattern of a mold is large, undulation, etc., is caused at the optical transmit portion of the waveguide, and thus the efficiency decreases and a color drift occurs. Hence, in order to fill such a void, when the thickness of a resin is increased, a residual film under the pattern of an optical input portion and that of an optical output portion increase, resulting in a decrease in efficiency at the wide-angle side.

Hence, an objective of the present disclosure is to provide an optical waveguide which has a suppressed undulation at an optical transmit portion, and also has a suppressed residual film at an optical input portion and at an optical output portion, an optical waveguide mold to manufacture the optical waveguide, and a method for manufacturing the optical waveguide.

SOLUTION TO PROBLEM

In order to accomplish the above objective, an optical waveguide mold according to the present disclosure is for manufacturing an optical waveguide which is formed of a transparent substrate and of a resin formed on a surface of the transparent substrate, and which includes:

an optical transmit portion that is to transmit light;

an optical input portion that is to cause the light to enter the optical transmit portion; and

an optical output portion that is to cause the light to be output from the optical transmit portion,

the optical waveguide mold including:

a flat optical-transmit-portion pattern to form the optical transmit portion on the resin; and

at least either one of or both of an optical-input-portion pattern to form the optical input portion on the resin and an optical-output-portion pattern to form the optical output portion on the resin,

in which when it is defined that a depth of a recess of the optical-input-portion pattern or of the optical-output-portion pattern is B, a fill factor of a convexity thereof is FF, and a difference between a height of the optical-input-portion pattern or of the optical-output-portion pattern and a height of the optical-transmit-portion pattern is D, the optical waveguide mold satisfies a following equation:

$$0.9 \times B \times (1 - FF) \le D \le 1.1 \times B \times (1 - FF).$$

In this case, it is preferable that $D = B \times (1 - FF)$ should be satisfied.

Moreover, an optical waveguide mold according to the present disclosure is for manufacturing an optical waveguide which is formed of a transparent substrate and of a resin formed on a surface of the transparent substrate, and which includes:

an optical transmit portion that is to transmit light;

an optical input portion that is to cause the light to enter the optical transmit portion; and

an optical output portion that is to cause the light to be output from the optical transmit portion,

the optical waveguide mold including:

a flat optical-transmit-portion pattern to form the optical transmit portion on the resin;

an optical-input-portion pattern to form the optical input portion on the resin; and

an optical-output-portion pattern to form the optical output portion on the resin,

in which when it is defined that a depth of a recess of the optical-input-portion pattern is $B_1$, a fill factor of a convexity thereof is $FF_1$, a depth of a recess of the optical-output-portion pattern is $B_2$, a fill factor of a convexity thereof is $FF_2$, a difference between a height of the optical-input-portion pattern and a height of the optical-transmit-portion pattern is $D_1$, and a difference between a height of the optical-output-portion pattern and the height of the optical-transmit-portion pattern is $D_2$, the optical waveguide mold satisfy following equations:

$$0.9 \times B_1 \times (1 - FF_1) \le D_1 \le 1.1 \times B_1 \times (1 - FF_1);$$

and

$$0.9 \times B_2 \times (1 - FF_2) \le D_2 \le 1.1 \times B2 \times (1 - FF_2).$$

In this case, $D_1 = D_2$ may be satisfied. Moreover, $B_1 - D_1 = B_2 - D_2$ may be satisfied.

Furthermore, it is preferable that

$$D_1 = B_1 \times (1 - FF_1);$$

and

$$D_2 = B_2 \times (1 - FF_2)$$

should be satisfied.

Still further, an optical waveguide mold according to the present disclosure is for manufacturing an optical waveguide which is formed of a transparent substrate and of a resin formed on a surface of the transparent substrate, and which includes:

first and second optical transmit portion each being to transmit light;

an optical input portion that is to cause the light to enter the first optical transmit portion;

an optical enlarging portion which is placed between the first optical transmit portion and the second optical transmit portion, and which controls the incident light from the first optical transmit portion and outputs to the second optical transmit portion so as to enlarge exit pupil; and

an optical output portion that is to cause the light to be output from the second optical transmit portion,

the optical waveguide mold including:

a flat first-optical-transmit-portion pattern to form the first optical transmit portion on the resin;

a flat second-optical-transmit-portion pattern to form the second optical transmit portion on the resin;

an optical-input-portion pattern to form the optical input portion on the resin;

an optical-output-portion pattern to form the optical output portion on the resin; and

an optical-enlarging-portion pattern to form the optical enlarging portion on the resin,

in which when it is defined that a depth of a recess of the optical-input-portion pattern is $B_1$, a fill factor of a convexity thereof is $FF_1$, a depth of a recess of the optical-output-portion pattern is $B_2$, a fill factor of a convexity thereof is $FF_2$, a depth of a recess of the optical-enlarging-portion pattern is $B_3$, and a fill factor of a convexity thereof is $FF_3$, a difference $D_1$ between a height of the optical-input-portion pattern and a height of the first-optical-transmit-portion pattern, a difference $D_2$ between a height of the optical-output-portion pattern and a height of the second-optical-transmit-portion pattern, and a difference $D_3$ between a height of the optical-input-portion pattern and the height of the first-optical-transmit-portion pattern or of the second-optical-transmit-portion pattern satisfy following equations:

$$0.9 \times B_1 \times (1 - FF_1) \leq D_1 \leq 1.1 \times B_1 \times (1 - FF_1);$$

$$0.9 \times B_2 \times (1 - FF_2) \leq D_2 \leq 1.1 \times B_2 \times (1 - FF_2);$$

and

$$0.9 \times B_3 \times (1 - FF_3) \leq D_3 \leq 1.1 \times B_3 \times (1 - FF_3).$$

In this case, $D_1 = D_2 = D_3$ may be satisfied. Moreover, $B_1 - D_1 = B_2 - D_2 = B_3 - D_3$ may be satisfied.

Furthermore, it is preferable that:

$$D_1 = B_1 \times (1 - FF_1);$$

$$D_2 = B_2 \times (1 - FF_2);$$

and

$$D_3 = B_3 \times (1 - FF_3)$$

should be satisfied.

Yet still further, a method for manufacturing an optical waveguide according to the present disclosure includes: carrying out imprint molding using the above-described optical waveguide mold.

It is preferable that a refractive index of the resin should be greater than or equal to 1.8.

It is preferable that the imprint molding should be carried out in such a way that a thickness of a residual film of the resin formed by at least any one of the optical-input-portion pattern, the optical-output-portion pattern and the optical-enlarging-portion pattern becomes smaller than or equal to 100 nm.

Moreover, an optical waveguide according to the present disclosure is formed of a transparent substrate, and of a resin formed on a surface of the transparent substrate, the optical waveguide including:

an optical transmit portion which is formed of the transparent substrate and of the flat resin formed on the surface of the transparent substrate, and which is to transmit light;

an optical input portion which is formed of the resin formed as a grating pattern on the surface of the transparent substrate, and which is to cause the light to enter the optical transmit portion; and

an optical output portion which is formed of the resin formed as a grating pattern on the surface of the transparent substrate, and which is to cause the light to be output from the optical transmit portion,

in which when it is defined that a height of a convexity of the grating pattern of the optical input portion is $b_1$, a fill factor of the convexity thereof is $ff_1$, a thickness of a residual film thereof is $d_1$, a height of a convexity of the grating pattern of the optical output portion is $b_2$, a fill factor of the convexity thereof is $ff_2$, and a thickness of a residual film thereof is $d_2$, a thickness t of the resin at the optical transmit portion satisfy the following equations:

$$0.9 \times (d_1 + b_1 \times ff_1) \leq t \leq 1.1 \times (d_1 + b_1 \times ff_1);$$

and

$$0.9 \times (d_2 + b_2 \times ff_2) \leq t \leq 1.1 \times (d_2 + b_2 \times ff_2).$$

In this case, $d_1 = d_2$ may be satisfied. Moreover, $b_1 + d_1 = b_2 + d_2$ may be satisfied.

It is preferable that $t = d_1 + b_1 \times ff_1 = d_2 + b_2 \times ff_2$ should be satisfied.

Furthermore, an optical waveguide according to the present disclosure is formed of a transparent substrate, and of a resin formed on a surface of the transparent substrate, the optical waveguide including:

first and second optical transmit portions each formed of the transparent substrate and of the flat resin formed on the surface of the transparent substrate, and each being to transmit light;

an optical input portion which is formed of the resin that is formed as a grating pattern on the surface of the transparent substrate, and which is to cause the light to enter the first optical transmit portion;

an optical enlarging portion which is placed between the first optical transmit portion and the second optical transmit portion, is formed of the resin that is formed as a pattern for enlarging on the surface of the transparent substrate, and controls the incident light from the first optical transmit portion and outputs to the second optical transmit portion so as to enlarge exit pupil; and

an optical output portion which is formed of the resin that is formed as a grating pattern on the surface of the transparent substrate, and which is to cause the light to be output from the second optical transmit portion,

in which when it is defined that a height of a convexity of the grating pattern of the optical input portion is $b_1$, a fill factor of the convexity thereof is $ff_1$, a thickness of a residual film thereof is $d_1$, a height of a convexity of the grating pattern of the optical output portion is $b_2$, a fill factor of the convexity thereof is $ff_2$, a thickness of a residual film thereof is $d_2$, a height of a convexity of the pattern for enlarging of the optical enlarging portion is $b_3$, a fill factor of the convexity thereof is $ff_3$, and a thickness of a residual film thereof is $d_3$, a thickness t of the resin at the first optical transmit portion and at the second optical transmit portion satisfies the following equations:

$$0.9 \times (d_1 + b_1 \times ff_1) \leq t \leq 1.1 \times (d_1 + b_1 \times ff_1);$$

$$0.9 \times (d_2 + b_2 \times ff_2) \leq t \leq 1.1 \times (d_2 + b_2 \times ff_2);$$

and

$$0.9 \times (d_3 + b_3 \times ff_3) \leq t \leq 1.1 \times (d_3 + b_3 \times ff_3).$$

In this case, $= d_2 = d_3$ may be satisfied. Moreover, $b_1 + d_1 = b_2 + d_2 = b_3 + d_3$ may be satisfied.

It is preferable that $t = d_1 + b_1 \times ff_1 = d_2 + b_2 \times ff_2 = d_3 + b_3 \times ff_3$ should be satisfied.

It is preferable that a refractive index of the resin should be greater than or equal to 1.8.

It is preferable that a thickness of a residual film of at least any one of the grating patterns of the optical input portion, of the optical output portion, and the pattern for enlarging of the optical enlarging portion should be smaller than or equal to 100 nm.

ADVANTAGEOUS EFFECTS OF INVENTION

An optical waveguide which has a suppressed undulation at an optical transmit portion, and also has a suppressed residual film at an optical input portion and at an optical output portion, an optical waveguide mold to manufacture the optical waveguide, and a method for manufacturing the optical waveguide can be provided.

BRIEF DESCRIPTION OF DRAWINGS

FIG. 1 is a schematic cross-sectional view illustrating a structure of an optical waveguide;

FIG. 2 is a diagram illustrating a relation between the refractive index of a substrate and the diffraction efficiency thereof;

FIG. 3 is a diagram illustrating a relation between the thickness of a residual film and the diffraction efficiency;

FIG. 4 is a diagram illustrating a method for manufacturing the optical waveguide by a conventional mold;

FIG. 5 is a diagram illustrating another method for manufacturing the optical waveguide by a conventional mold;

FIG. 6 is a diagram illustrating a state of a flat portion of the optical waveguide manufactured by a conventional mold;

FIG. 7 is a diagram illustrating the other method for manufacturing the optical waveguide by a conventional mold;

FIG. 8 is a schematic cross-sectional view illustrating a method for manufacturing the optical waveguide according to the present disclosure;

FIG. 9 is a diagram for describing a resin filling by the deflection of the mold;

FIG. 10 is a diagram for describing a condition in which a void is completely filled by deflection;

FIG. 11 is a diagram for describing a limit value for a deflection of a mold by pressurization;

FIG. 12 is a diagram illustrating a filling condition for a mold with a flat portion that has a length which is 3 mm;

FIG. 13 is a diagram illustrating a filling condition for a mold with a flat portion that has a length which is 2 mm;

FIG. 14 is a schematic cross-sectional view illustrating the method for manufacturing the optical waveguide according to the present disclosure;

FIG. 15 is a schematic cross-sectional view illustrating the method for manufacturing the optical waveguide according to the present disclosure;

FIG. 16 is a schematic perspective diagram illustrating an optical waveguide that includes an optical enlarging portion according to the present disclosure;

FIG. 17 is a schematic cross-sectional view illustrating the method for manufacturing the optical waveguide according to the present disclosure; and

FIG. 18 is a schematic cross-sectional view illustrating the method for manufacturing the optical waveguide according to the present disclosure.

# EP 4 763 477 A1

DESCRIPTION OF EMBODIMENTS

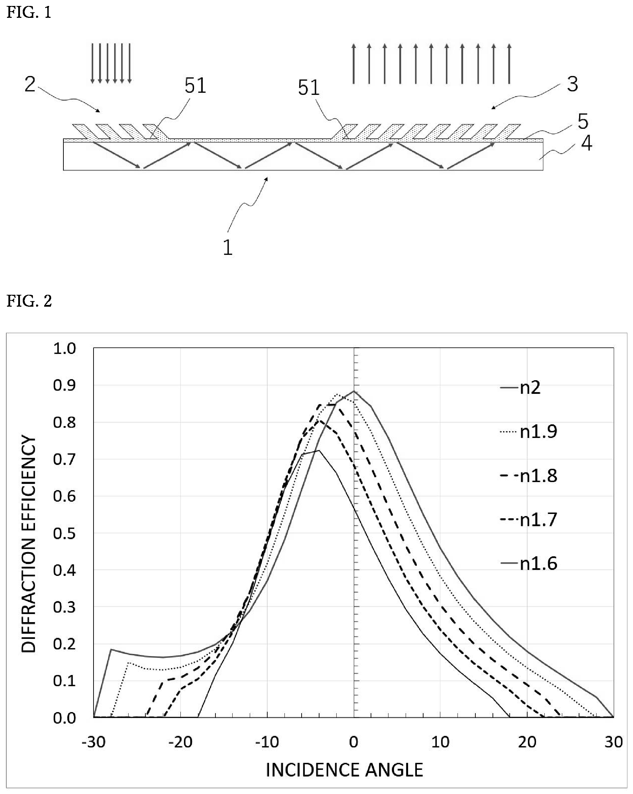

An optical waveguide is formed of, as illustrated in, for example, FIG. 1, a transparent substrate 4, and of a resin 5 that is formed on the surface of the transparent substrate 4. Moreover, the optical waveguide mainly includes an optical transmit portion 1, an optical input portion 2 and an optical output portion 3.

The optical transmit portion 1 is formed of the transparent substrate 4 and of the flat resin 5 that is formed on the surface of the transparent substrate 4, and is to transmit light. Light that is input from the optical input portion 2 is transmitted while being totally reflected in the optical transmit portion 1, and is output from the optical output portion 3.

The optical input portion 2 is formed of the resin 5 that is formed as a grating pattern on the surface of transparent substrate 4, and is to cause light to enter the optical transmit portion 1. The grating pattern can be in any shape as far as it can cause the light to enter the optical transmit portion 1. For example, it may be a pattern which can cause light to be diffracted so as to travel in the optical transmit portion 1 while being totally reflected, and may be a line-and-space shape having inclined convexities arranged periodically.

The optical output portion 3 is formed of the resin 5 that is formed as a grating pattern on the surface of transparent substrate 4, and is to cause the light to be output from the optical transmit portion 1. The grating pattern can be in any shape as far as it can cause the light to be output from the optical transmit portion 1. For example, it may be a pattern which can cause the light to be diffracted so as to be output from the transparent substrate 4 to the exterior, and may be a line-and-space shape having the inclined convexities arranged periodically.

Simulations were made for the optical waveguide with such a form. Note that the pitch of the grating pattern of the optical input portion was 420 nm, the height of the inclined convexity was 350 nm, the width was 210 nm, and the angle was 55 degrees. Moreover, the wavelength of incident light was 630 nm. FIG. 2 illustrates a relation between the incidence angle for each refractive index of the transparent substrate 4 and the diffraction efficiency of the optical input portion 2. As illustrated in FIG. 2, it becomes clear that the higher the refractive rate is, the higher the diffraction efficiency to be obtained becomes at the wide incidence angle. From this fact, a high refractive index material is required for the material of the optical waveguide. More specifically, it is preferable that the refractive index of the transparent substrate 4 and that of the resin 5 should be greater than or equal to 1.8.

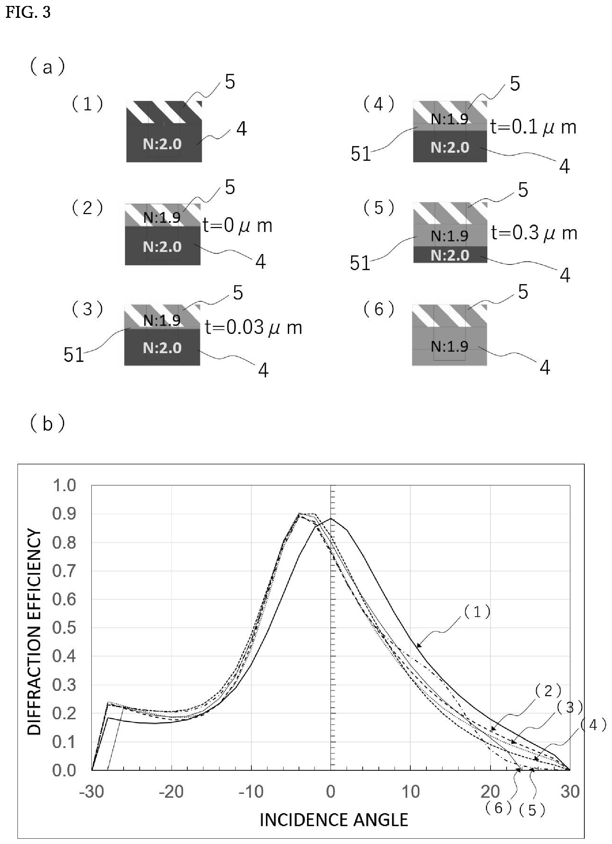

Moreover, when the grating pattern is formed by imprinting, a residual film 51 is formed under such a pattern. When there is no refractive index difference between the transparent substrate 4 and the resin 5, there is no adverse effect of the residual film, but under the current circumstances, the refractive index of the substrate is to be higher than the refractive index of the resin 5, i.e., the refractive index of the substrate is 2.0 and the refractive index of the resin 5 is 1.9, and thus there is a difference that is substantially 0.1. Moreover, as for the relation between the refractive index of the substrate and that of the resin 5, it is expected that the refractive index of the substrate is still higher than the refractive index of the resin 5 even if the refractive index of the material improves. Hence, simulations were made for, in which the grating pattern of the optical input portion 2 has the residual films 51, how the difference in the thickness of the residual film 51 affects to the diffraction efficiency of the optical input portion 2. Note that the pitch of the grating pattern of the optical input portion was 420 nm, the height of the inclined convexity was 350 nm, the width was 210 nm, and the angle was 55 degrees. Moreover, the wavelength of incident light was 630 nm. The refractive index of the substrate, the refractive index of the resin 5, and thickness of the residual film 51 all applied for the simulations are shown in table 1 and FIG. 3, part (a).

[TABLE 1]

|  | REFRACTIVE INDEX OF SUBSTRATE | REFRACTIVE INDEX OF RESIN | THICKNESS OF RESIDUAL FILM ($\mu$M) |
|---|---|---|---|
| (1) | 2.0 | 2.0 | 0 |
| (2) | 2.0 | 1.9 | 0 |
| (3) | 2.0 | 1.9 | 0.3 |
| (4) | 2.0 | 1.9 | 0.1 |
| (5) | 2.0 | 1.9 | 0.3 |
| (6) | 1.9 | 1.9 | 0 |

The results are shown in FIG. 3, part (b).

Regarding the simulation results, when the grating pattern with the refractive index that was 1.9 was placed on the substrate with the refractive index that was 2.0, the incidence angle was obtained which was ±30 degrees was obtained. It becomes clear that, however, when the residual film 51 is thick, the efficiency at the wide-angle side decreases, and thus it is preferable that the residual film 51 should be suppressed to be smaller than or equal to 30 nm. It is also confirmed from the simulations that, when the refractive index of the resin 5 increases to 1.95, the efficiency at the wide-angle side can be maintained when the residual film 51 is still smaller than or equal to 100 nm.

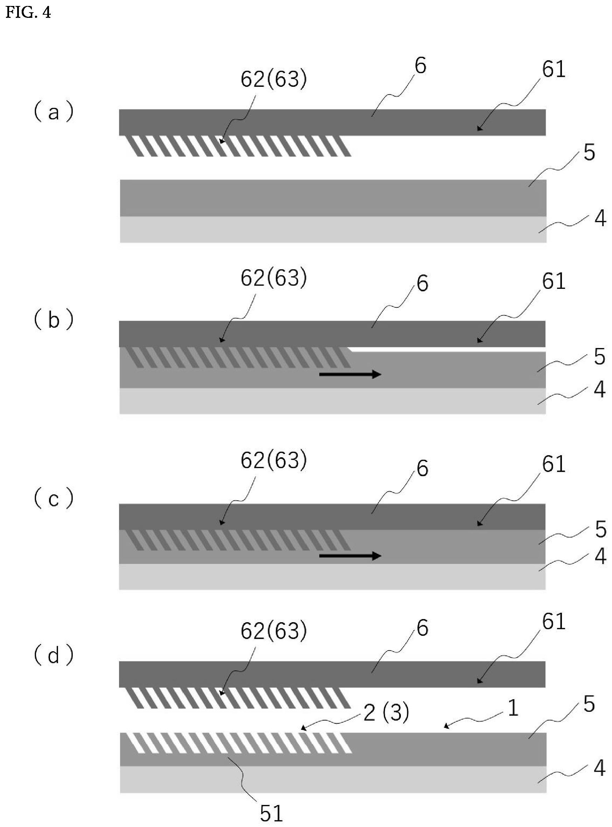

A description will be given of a case in which the grating pattern of the optical input portion 2 of the optical waveguide and that of the optical output portion 3, and the flat portion of the optical transmit portion 1 are formed by the resin 5 on the transparent substrate 4 by imprinting. An optical waveguide mold 6 to be applied for imprinting mainly includes, as illustrated in FIG. 4, an optical-transmit-portion pattern 61, and at least either one of or both of an optical-input-portion pattern 62 and an optical-output-portion pattern 63. The material of the optical waveguide mold 6 is not limited to any particular material as far as it is applicable for imprinting, and for example, a glass or a resin is applicable.

The optical-transmit-portion pattern 61 is a flat pattern to form the flat portion of the optical transmit portion 1 on the resin 5.

The optical-input-portion pattern 62 is to form the optical input portion 2 on the resin 5. The optical-input-portion pattern 62 is not limited to any particular pattern as far as it can form, on the resin 5, the optical input portion 2, but for example, may be an inverted pattern of the above-described grating pattern of the optical input portion 2.

The optical-output-portion pattern 63 is to form the optical output portion 3 on the resin 5. The optical-output-portion pattern 63 is not limited to any particular pattern as far as it can form, on the resin 5, the optical output portion 3, but for example, may be an inverted pattern of the above-described grating pattern of the optical output portion 3.

FIG. 4, part (a) is a diagram illustrating a state of the resin 5 at the time of molding when the thickness of the resin 5 applied on the transparent substrate 4 before imprint molding is thick. When the thickness of the resin 5 before imprint molding is thick, and when the resin 5 is pressurized by the optical waveguide mold 6, as illustrated FIG. 4, parts (b) and (c), since the resin 5 is likely to move in the horizontal direction from the grating-pattern side to the flat-portion side, the molding can be carried out. As illustrated in FIG. 4, part (d), however, the residual film 51 becomes thick.

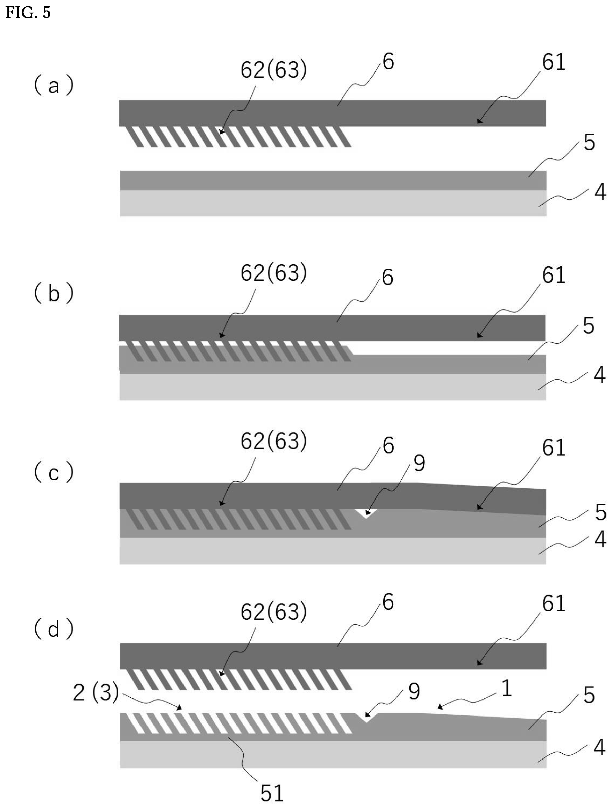

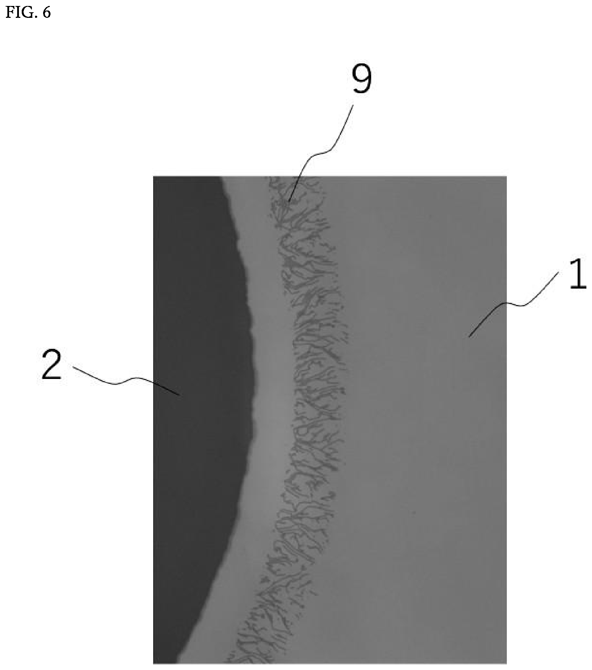

Conversely, FIG. 5, part (a), illustrates a state of the resin 5 at the time of molding when the thickness of the resin 5 applied on the transparent substrate 4 before imprint molding is thin. When the resin 5 before molding is made thin, and when the resin 5 is pressurized by the optical waveguide mold 6, as illustrated in FIG. 5, parts (b) and (c), it is difficult for the resin 5 to move in the horizontal direction from the grating-pattern side to the flat-portion side, and thus, as illustrated in FIG. 5, part (d) and FIG. 6, the void 9 remains even after the molding. This becomes a cause of an undulation of the flat portion.

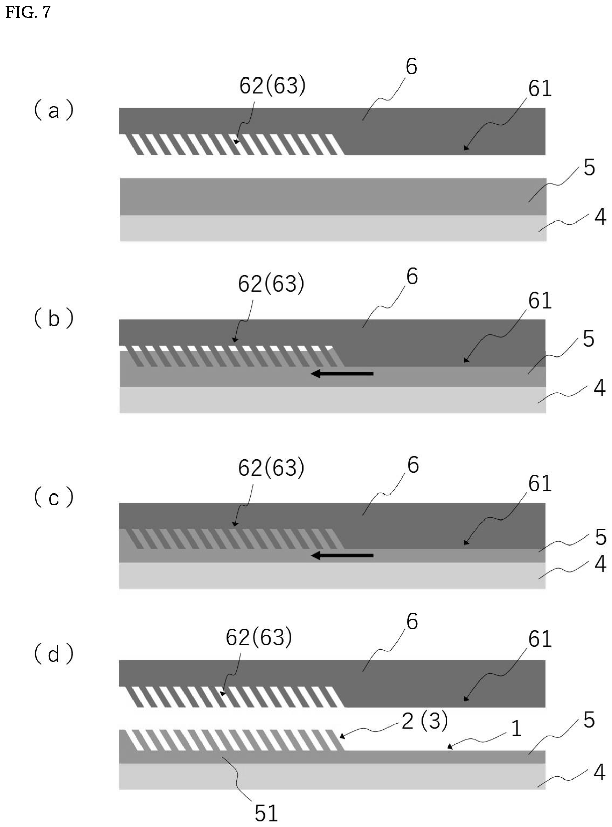

Moreover, FIG. 7, part (a) is a diagram illustrating a state of the resin 5 at the time of molding when a void of the optical-transmit-portion pattern 61 of the optical waveguide mold 6 is eliminated so as not to leave the void 9 after the molding. When the void of the optical-transmit-portion pattern 61 of the optical waveguide mold 6 is eliminated, as illustrated in FIG. 7, parts (b) and (c), since the resin 5 moves in the horizontal direction from the optical-transmit-portion-pattern-61 side to the grating-pattern side when the resin 5 is pressurized by the optical waveguide mold 6, as illustrated in FIG. 7, part (d), the residual film 51 of the grating pattern after the molding becomes thick.

In view of the above-described facts, when the residual film 51 of the grating pattern to be made thin is desirable, it is preferable that the optical transmit portion 1, the optical input portion 2 and the optical output portion 3 should be formed by a scheme such that the movement of the resin 5 in the horizontal direction is suppressed as much as possible when the resin 5 is pressurized by the optical waveguide mold 6.

Hence, a description will be below given of the optical waveguide mold 6 according to the present disclosure that suppresses the movement of the resin 5 in the horizontal direction when the resin 5 is pressurized by the optical waveguide mold 6. The optical waveguide mold 6 according to the present disclosure is to manufacture the optical waveguide which is formed of the transparent substrate 4 and of the resin 5 that is formed on the surface of the transparent substrate 4, and which includes the optical transmit portion 1 to transmit light, the optical input portion 2 to cause the light to enter the optical transmit portion 1, and the optical output portion 3 that causes the light to be output from the optical transmit portion 1. Moreover, as described above, the optical waveguide mold 6 mainly includes the optical-transmit-portion pattern 61, and at least either one of or both of the optical-input-portion pattern 62 and the optical-output-portion pattern 63. The material of the optical waveguide mold 6 is not limited to any particular material as far as it is applicable for imprinting, but for example, a conventionally known material like a glass is applicable.

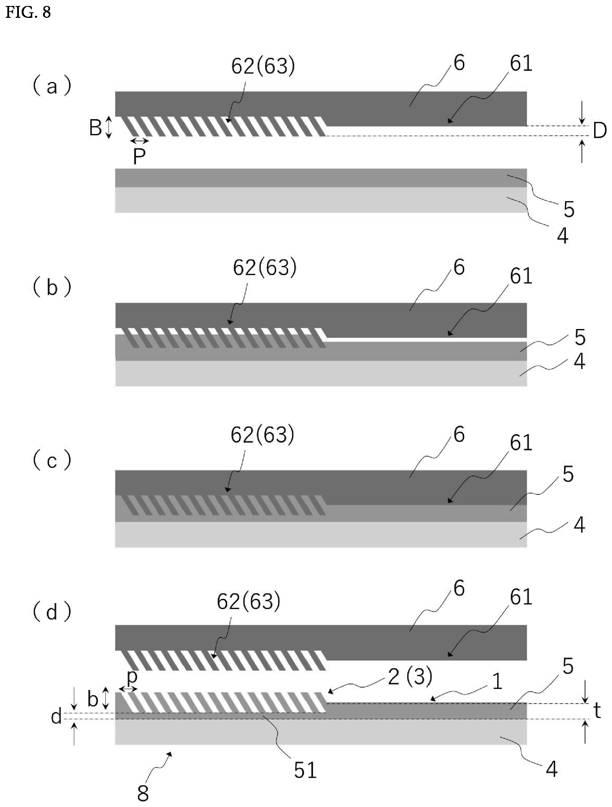

In order to suppress the movement of the resin 5 in the horizontal direction when the resin 5 is pressurized by the optical waveguide mold 6, it is appropriate that the void (a recess) of the optical-input-portion pattern 62 or the optical-output-portion pattern 63 and the void of the optical-transmit-portion pattern 61 adjacent to such an optical-input-portion pattern 62 or an optical-output-portion pattern 63 should be balanced in volume per a unit space. More specifically, as illustrated in FIG. 8, part (a), when it is defined that the pitch of the optical-input-portion pattern 62 or the optical-output-portion pattern 63 is P, the depth of the recess is B, the fill factor of the convexity thereof is FF, and a difference between the height of the optical-input-portion pattern 62 or the optical-output-portion pattern 63 and the height of the optical-transmit-portion pattern 61 is D, it is preferable that $P \times D = P \times B \times (1 - FF)$, i.e., $D = B \times (1 - FF)$.

The fill factor of the convexity means, as viewed from the side at which the surface (will be referred to as a pattern surface below) including the optical-input-portion pattern 62 of the optical waveguide mold 6 and the optical-output-portion pattern 63 thereof are present, the percentage of the area of the convexity relative to the area of the pattern surface. Moreover, the depth of the concavity means the height of the vertex of the convexity relative to the bottom of the recess in other words. When there is a variability in depth of the recess of such a pattern, the average depth of the whole recesses of each pattern may be adopted. Moreover, the difference between the height of the optical-input-portion pattern 62 or the optical-output-portion pattern 63 and the height of the optical-transmit-portion pattern 61 means, in other words, as illustrated in FIG. 8, part (a), the height of the vertex of the convexity of the optical-input-portion pattern 62 or optical-output-portion pattern 63 relative to the flat surface of the optical-transmit-portion pattern 61.

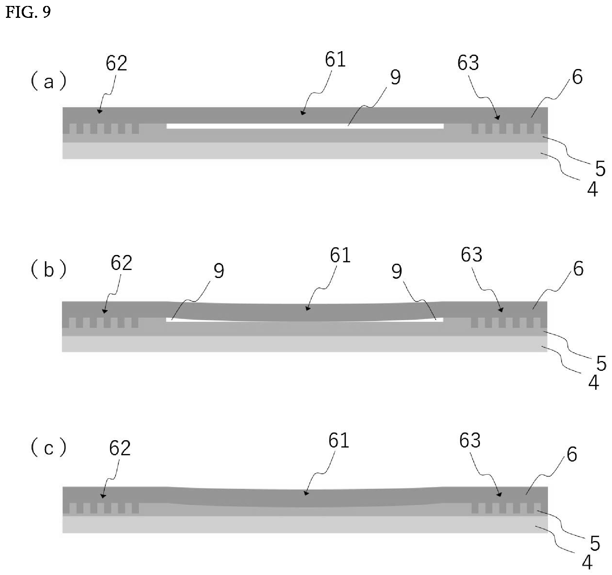

Note that when D = B × (1 -FF) is not satisfied and the volume of the void per a unit space is not balanced, if such unbalancing falls in a minor error, molding can be still carried out by the convexity-shape deflection of the optical waveguide mold 6 at the resin-5 side or the opposite side thereto. More specifically, as illustrated in FIG. 9, part (a), the resin 5 at the bottom of the optical-input-portion pattern 62 and that of the optical-output-portion pattern 63 move by pressurization, and a filled portion spreads near such a pattern, and thus the void 9 of the optical-transmit-portion pattern 61 becomes narrow. As illustrated in FIG. 9, part (b), when it is further pressurized, the optical waveguide mold 6 is deflected and pushes away the resin 5 to the surroundings. At this time, the void 9 is left when the deflection of the optical waveguide mold 6 is little, but when it is sufficiently deflected, as illustrated in FIG. 9, part (c), the resin 5 pushed at the center can fill the surrounding voids.

Hence, it is preferable that the error in volumes between the voids per a unit space should be at least smaller than or equal to 10 %. In this case, it is appropriate that the following formula should be satisfied:

$$0.9 \times B \times (1 - FF) \leq D \leq 1.1 \times B \times (1 - FF)$$

Needless to say, it is preferable that the error should be as small as possible, preferably, smaller than or equal to 5 %, more preferably, smaller than or equal to 3 %.

Accordingly, when the resin 5 is pressurized by the optical waveguide mold 6, as illustrated in FIG. 8, parts (b) and (c), the movement of the resin 5 in the horizontal direction hardly occurs. Hence, as illustrated in FIG. 8, part (d), the residual film 51 of the grating pattern after the molding can be made thin, and the optical transmit portion 1 can be formed in a good shape without undulation and the void 9.

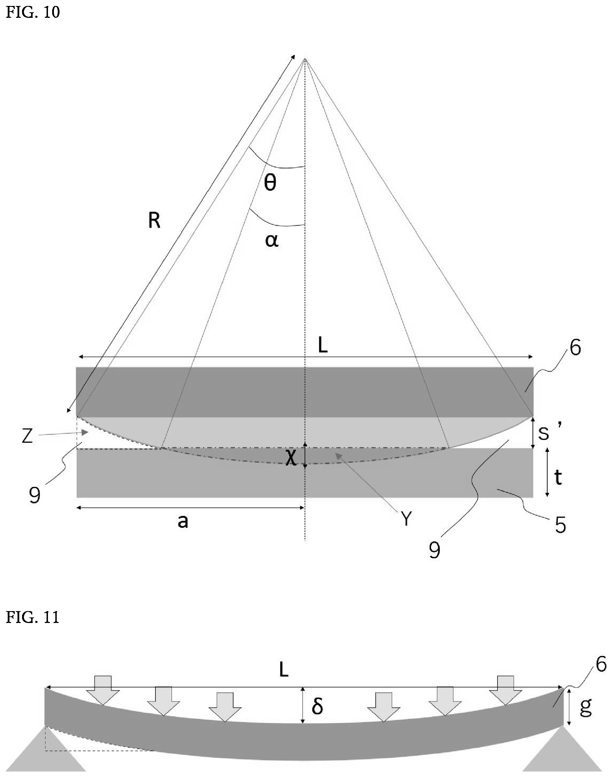

A description will be given of a condition in which the molding without a void 9 can be carried out by the deflection of the optical waveguide mold 6. First of all, as illustrated in FIG. 10, it is defined that the area of the resin 5 pushed away by the deflection of the optical waveguide mold 6 is Y, and the area of a clearance between end portions after the optical waveguide mold 6 is deflected is Z.

When the curvature radius of the deflection is approximated with R, and when it is defined that the maximum depth when the resin 5 is pushed away is x, the height of the clearance is s', the angle from the vertical line to a point on the boundary between the void and the resin 5 is $\alpha$, and the angle from the vertical line to the point of the void at the maximum height is $\theta$, the followings are satisfied.

$$Y = R^2(\alpha - \cos\alpha\sin\alpha)$$

(The difference between an area $\alpha R^2$ of a sector with the radius R and with an angle $2\alpha$, and an area $R^2\cos\alpha\sin\alpha$ of a triangle with a height $R\cos\alpha$ and with a bottom side length $2R\sin\alpha$)

$$(\cos\alpha = \cos\theta + (s'/R))$$

$$Z \cong s'(a - R\sin\alpha)/2$$

(The area of a triangle with a bottom side length a - $R\sin\alpha$ and with a height s')

In this case, the condition in which all voids are filled by the deflection of the optical waveguide mold 6 is satisfied when Y = 2Z, the following equation (1) is satisfied:

$$R^2(\alpha - \cos\alpha\sin\alpha) = s'(a - R\sin\alpha) \quad \text{Equation (1)}.$$

Moreover, as for the limit value at which the optical waveguide mold 6 is deflected by pressurization, as illustrated in FIG. 11, the following equation (2) is satisfied when, from the model of a double flexed beam to which uniform pressure p is applied, it is defined that the curvature radius is R', the length of the beam is L, and the degree of the deflection in the vertical direction is $\delta$:

$$R' = (L/2)^2/(2\delta) \quad \text{Equation (2)}.$$

$$(\delta = 5pL^4/(384EI))$$

where:

$$I = g^3/12$$

E is the Young's modulus of the optical waveguide mold, and
g is the thickness of the optical waveguide mold

Accordingly, the mold can be deflected until the voids are completely filled only when the curvature radius R of the filled condition is greater than or equal to the curvature radius R' (R ≥ R'). However, the filling cannot be made unless an applied film thickness t is thicker than a pushing depth $\chi$ of the beam.

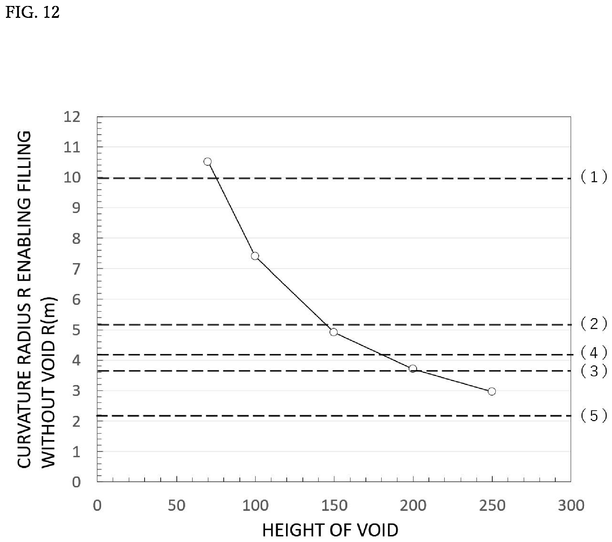

FIG. 12 is a diagram illustrating a relation which is calculated based on the equation (1) and which is between the height S' of the void 9 between the resin 5 and the optical waveguide mold 6, and, the curvature radius R by the deflection of the optical waveguide mold 6 necessary to completely fill the resin 5. Moreover, dashed lines (1) to (5) in FIG. 12 each represent the value of the curvature radius R' calculated from the differential pressure applied to both of the surfaces of the optical waveguide mold 6 when imprint molding was carried out, and from the thickness of the optical waveguide mold 6 based on the equation (2). A thickness g of the optical-transmit-portion pattern 61 of the optical waveguide mold and pressure p were as follows.

Dashed line (1), g: 0.7 mm, p: 0.25 MPa

Dashed line (2), g: 0.7 mm, p: 0.5 MPa

Dashed line (3), g: 0.7 mm, p: 0.75 MPa

Dashed line (4), g: 0.5 mm, p: 0.25 MPa

Dashed line (5), g: 0.5 mm, p: 0.5 MPa

Note that a width L of the optical-transmit-portion pattern 61 of the optical waveguide mold was 3 mm. Moreover, the applied material of the optical waveguide mold was a glass with a Young's modulus E that was 73.6 GPa.

Since the curvature R' is proportional to the cubic thickness $\alpha$ of the optical-transmit-portion pattern 61 of the optical waveguide mold, by setting the thickness $\alpha$ from 0.5 mm to 0.7 mm, the curvature radius R' for deflection sufficient to filling by pressurization can be accomplished.

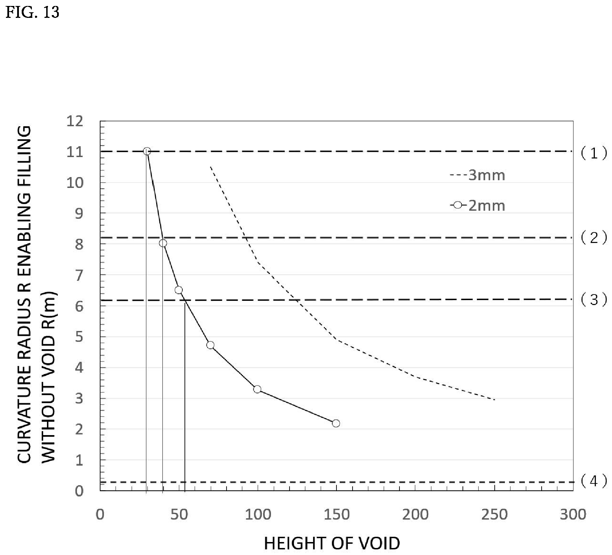

Furthermore, an examination was also carried out when the width L of the optical-transmit-portion pattern 61 of the optical waveguide mold was 2 mm. FIG. 13 is a diagram illustrating the relation which is calculated based on the equation (1) and which is between the height s' of the void between the resin 5 and the optical waveguide mold 6, and, the curvature radius R by the deflection of the optical waveguide mold 6 necessary to fill the resin 5 without void. Furthermore, dashed lines (1) to (4) in FIG. 13 each represent the value of the curvature radius R' which is calculated from the differential pressure applied to both of the surfaces of the optical waveguide mold 6 when imprint molding was carried out, and from the thickness of the optical waveguide mold 6 based on the equation (2). The thickness g of the optical-transmit-portion pattern 61 of the optical waveguide mold and the pressure p were as follows.

Dashed line (1), g: 0.7 mm, p: 0.75 MPa

Dashed line (2), g: 0.7 mm, p: 1.5 MPa

Dashed line (3), g: 0.7 mm, p: 2 MPa

Dashed line (4), g: 0.7 mm, p: 0.1 MPa

Note that, as for the dashed lines (1) to (3), the material of the optical waveguide mold was a glass with the Young's modulus E that was 73.6 GPa. Moreover, as for the dashed line (4), polyethylene terephthalate (PET) with the Young's modulus E that was 4 GPa was applied.

As illustrated in FIG. 13, when the width L was 2 mm, in order to carry out the filling so as to eliminate void, it is necessary to further increase the deflection of the optical waveguide mold, and thus the filling becomes further difficult.

Even if the pressurization is set to 2 MPa, it is still difficult to carry out the filling unless the void is smaller than or equal to 50 nm, and thus the filling by the deflection only is substantially impossible. Hence, the balance in volume per a unit space is important which is between the void (the recess) of the optical-input-portion pattern 62 or the optical-output-portion pattern 63 and the void of the optical-transmit-portion pattern 61 adjacent to the optical-input-portion pattern 62 or the optical-output-portion pattern 63. Note that within a range in which the filling can be carried out, as for the necessary applied film thickness t, since the push-in depth x at the void that is 50 nm is greater than or equal to 27 nm, an adverse effect of the film thickness t is substantially ignorable.

Next, a description will be given of a method for manufacturing the optical waveguide according to the present disclosure with reference to FIG. 8. The method for manufacturing the optical waveguide according to the present disclosure is to form the optical waveguide which is formed of the transparent substrate 4 and of the resin 5 that is formed on the surface of the transparent substrate 4, and which includes the optical transmit portion 1 to transmit light, the optical input portion 2 to cause the light to enter the optical transmit portion 1, and the optical output portion 3 to cause the light to be output from the optical transmit portion 1. The method of manufacturing the optical waveguide is to perform imprint molding using the above-described optical waveguide mold 6 of the present disclosure. As described above, when the pitch of the optical-input-portion pattern 62 or the optical-output-portion pattern 63 is P, the depth of the recess is B, the fill factor of the convexity thereof is FF, and the depth of the optical-transmit-portion pattern 61 adjacent to the optical-input-portion pattern 62 or the optical-output-portion pattern 63 is D, the optical waveguide mold 6 that satisfies at least $0.9 \times B \times (1 - FF) \leq D \leq 1.1 \times B \times (1 - FF)$, preferably, $0.95 \times B \times (1 - FF) \leq D \leq 1.05 \times B \times (1 - FF)$, more preferably, $0.97 \times B \times (1 - FF) \leq D \leq 1.03 \times B \times (1 - FF)$ is to be applied. Most preferably, one that satisfies $D = B \times (1 - FF)$ is to be applied.

First, the resin 5 is applied on the surface of the transparent substrate 4. The resin 5 is not limited to any particular resin as far as it is a transparent resin that is applicable for imprint molding, and an example is a photo-curable resin, a thermosetting resin or a thermoplastic resin. More specifically, an acrylic-based photo-curable resin is applicable. For example, the resin 5 may be applied on the transparent substrate 4 by a well-known scheme like spin coater. It is preferable that the refractive index of the resin 5 should be greater than or equal to 1.8.

Nex, at least either one of or both of the optical input portion 2 or the optical output portion 3 which form the grating patterns, and the optical transmit portion 1 which forms the flat surface are transferred to the photo-curable resin by imprinting using the optical waveguide mold 6. More specifically, as illustrated in FIG. 8, parts (b) and (c), the resin 5 with the fluidity on the transparent substrate 4 is pressurized by the optical waveguide mold 6, and the resin 5 is filled to the optical-transmit-portion pattern 61, the optical-input-portion pattern 62, and the optical-output-portion pattern 63. At this time, it is preferable that the optical waveguide mold 6 should be pressed until the thickness d of the residual film 51 of the resin 5 becomes smaller than or equal to 100 nm, more preferably, smaller than or equal to 30 nm. The residual film 51 means, in this case, the portion where the resin is thinnest for each of the grating pattern of the optical input portion 2 formed by the optical-input-portion pattern 62 and the grating pattern of the optical output portion 3 formed by the optical-output-portion pattern 63.

Subsequently, the resin 5 is solidified and is demolded as illustrated in FIG. 8, part (d), and the optical waveguide according to the present disclosure can be manufactured.

Next, a description will be given of the optical waveguide of the present disclosure manufactured as described above. The optical waveguide according to the present disclosure is formed of the transparent substrate 4, and of the resin 5 that is formed on the surface of the transparent substrate 4. Moreover, the optical waveguide mainly includes the optical input portion 2, the optical output portion 3, and the optical transmit portion 1.

The optical transmit portion 1 is formed of the transparent substrate 4 and of the flat resin 5 formed on the surface of the transparent substrate 4, and is to transmit light. Incident light from the optical input portion is transmitted by optical input portion 2 while being totally reflected in the optical transmit portion 1, and is output from the optical output portion 3.

The optical input portion 2 is formed of the resin 5 that is formed as the grating pattern on the surface of the transparent substrate 4, and is to cause the light to enter the optical transmit portion 1. The shape of the grating pattern is not limited to any particular shape as far as it can cause the light to enter the optical transmit portion 1. For example, it may be a pattern which can cause the light to be diffracted so as to be totally reflected in the optical transmit portion 1, and may be a line-and-space shape having the inclined convexities arranged periodically.

The optical output portion 3 is formed of the resin 5 that is formed as the grating pattern on the surface of the transparent substrate 4, and is to cause the light to be output from the optical transmit portion 1. The shape of the grating pattern is not limited to any particular shape as far as it can cause the light to be output from the optical transmit portion 1, but for example, it may be a pattern which can cause the light to be diffracted so as to be output from the transparent substrate 4 to the exterior, and may be a line-and-space shape having the inclined convexities arranged periodically.

The transparent substrate 4 is a base to form, on the resin 5, the flat portion of the optical transmit portion 1, and the patterns of the optical input portion 2 and of the optical output portion 3. Moreover, it is to transmit the incident light from the optical input portion 2 to the optical output portion 3. Any material is applicable as far as it can transmit light from the optical input portion 2 to the optical output portion 3, and for example, a glass is applicable. Furthermore, in view of the above-described simulation results, it is preferable that the refractive index of the transparent substrate 4 should be greater than or equal to 1.8, more preferably, greater than or equal to 1.9, and further preferably, greater than or equal to 2.0.

The resin 5 is to form the patterns of the optical input portion 2, the optical output portion 3, and the optical transmit portion 1. Any material is applicable as far as it can form the optical transmit portion 1, and the pattern of the optical input portion 2 and that of the optical output portion 3. Moreover, in view of the above-described simulation results, it is preferable that the refractive index of the transparent substrate 4 and that of the resin 5 should be greater than or equal to 1.8, more preferably, greater than or equal to 1.9, further preferably, greater than or equal to 1.95.

It is preferable that the optical waveguide according to the present disclosure should be formed so as to satisfy, when it is defined that the height of the convexity of the grating pattern of the optical input portion 2 or of the optical output portion 3 is b, the fill factor of the convexity thereof is ff, the thickness of the residual film 51 thereof is d, and the thickness of the resin 5 of the optical transmit portion 1 adjacent to such a grating pattern is t, at least $0.9 \times (d+b \times ff) \le t \le 1.1 \times (d+b \times ff)$, preferably, $0.95 \times (d+b \times ff) \le t \le 1.05 \times (d+b \times ff)$, more preferably, $0.97 \times (d+b \times ff) \le t \le 1.03 \times (d+b \times ff)$. Most preferably, when it is formed so as to satisfy $t = d+b \times ff$, a good shape that has little undulation of the optical transmit portion 1 and void 9. Note that the fill factor of the convexity means the percentage of the area of the convexity relative to the area of the pattern surface. The fill factor ff of the convexity of the grating pattern of the optical input portion 2 of the optical waveguide or of the optical output portion 3 thereof basically becomes the same value as that of the fill factor (1 - FF) of the recess of the optical-input-portion pattern 62 or of the optical-output-portion pattern 63. Moreover, the depth D of the optical-transmit-portion pattern 61 means, as illustrated in FIG. 8, part (a), the difference between the height of the flat surface of the optical-transmit-portion pattern 61 and the height of the vertex of the convexity of the optical-input-portion pattern 62 or of the optical-output-portion pattern 63.

It is preferable that the thickness d of the residual film 51 of the grating pattern of the optical input portion 2 or of the optical output portion 3 should be smaller than or equal to 100 nm, preferably, 30 nm, since the diffraction efficiency at the wide-angle side improves.

Note that, although the above description is given of the optical waveguide mold 6 which has the same depth B of the optical-input-portion pattern 62 and that of the optical-output-portion pattern 63 and which has the same difference D between the height of the optical-input-portion pattern 62 or of the optical-output-portion pattern 63 and that of the optical-transmit-portion pattern 61, those may be different. In this case, the optical waveguide mold 6 is to manufacture the optical waveguide which is formed of the transparent substrate 4 and of the resin 5 that is formed on the surface of the transparent substrate 4, and which includes the optical transmit portion 1 that is to transmit light, the optical input portion 2 that causes the light to enter the optical transmit portion 1, and the optical output portion 3 that causes the light to be output from the optical transmit portion 1. This mold includes the flat optical-transmit-portion pattern to form the optical transmit portion 1 on the resin 5, the optical-input-portion pattern to form the optical input portion 2 on the resin 5, and the optical-output-portion pattern to form the optical output portion 3 on the resin 5. Moreover, it is appropriate that the optical waveguide mold 6 should satisfy, when it is defined that the depth of the recess of the optical-input-portion pattern is $B_1$, the fill factor of the convexity thereof is $FF_1$, the depth of the recess of the optical-output-portion pattern is $B_2$, the fill factor of the convexity thereof is $FF_2$, the difference between the height of the optical-input-portion pattern and the height of the optical-transmit-portion pattern is $D_1$, and the difference between the height of the optical-output-portion pattern and the height of the optical-transmit-portion pattern is $D_2$, the following equations:

$$0.9 \times B_1 \times (1 - FF_1) \le D_1 \le 1.1 \times B_1 \times (1 - FF_1);$$

and

$$0.9 \times B_2 \times (1 - FF_2) \le D_2 \le 1.1 \times B2 \times (1 - FF_2).$$

Note that although an error up to $\pm 10\%$ is permitted in the equations, the smaller error is preferable that is smaller than or equal to 5 %, more preferably, smaller than or equal to 3 %.

When imprint molding is carried out using the optical waveguide mold 6, the manufactured optical waveguide is formed of the transparent substrate 4 and of the resin 5 that is formed on the surface of the transparent substrate 4, and includes the optical transmit portion 1 which is formed of the transparent substrate 4 and of the flat resin 5 formed on the surface of the transparent substrate 4, and which is to transmit light, the optical input portion 2 which is formed of the resin 5 that is formed as the grating pattern on the surface of the transparent substrate 4, and which is to cause the light to enter the optical transmit portion 1, and the optical output portion 3 which is formed of the resin 5 that is formed as the grating pattern on the surface of the transparent substrate 4, and which is to cause the light to be output from the optical transmit portion 1. Moreover, when it is defined that the height of the convexity of the grating pattern of the optical input portion 2 is $b_1$, the fill factor of the convexity thereof is $ff_1$, the thickness of the residual film thereof is $d_1$, the height of the convexity of the grating pattern of optical output portion 3 is $b_2$, the fill factor of the convexity thereof is $ff_2$, and the thickness of the residual film thereof is $d_2$, the thickness t of the resin 5 at the optical transmit portion 1 satisfy the following equations:

$$0.9 \times (d_1 + b_1 \times ff_1) \leq t \leq 1.1 \times (d_1 + b_1 \times ff_1);$$

and

$$0.9 \times (d_2 + b_2 \times ff_2) \leq t \leq 1.1 \times (d_2 + b_2 \times ff_2).$$

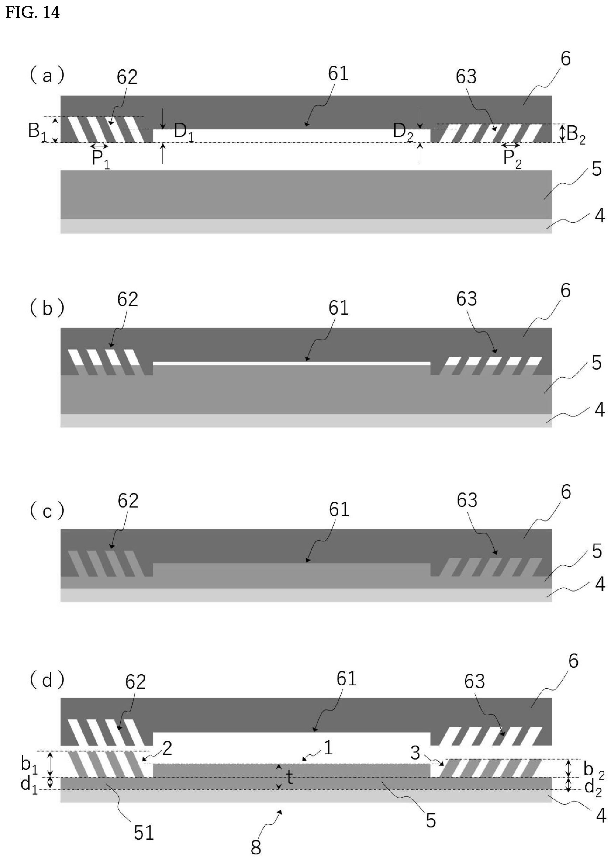

FIG. 14 is a schematic cross-sectional view illustrating a manufacturing process of the optical waveguide in which, although respective positions of the vertex of the optical-input-portion pattern 62 and that of the optical-output-portion pattern 63 relative to the flat surface of the optical-transmit-portion pattern 61 of the optical waveguide mold 6 are aligned ($D_1 = D_2$), respective positions of the bottom of the optical-input-portion pattern 62 of optical waveguide mold 6 and that of the optical-output-portion pattern 63 thereof differ from each other.

In this case, as for the manufactured optical waveguide, as illustrated in FIG. 14, part (d), although the thickness of the residual film of the grating pattern of the optical input portion 2 and of the optical output portion 3 are consistent ($d_1 = d_2$), the height $b_1$ of the convexity of the grating pattern of the optical input portion 2 and the height $b_2$ of the convexity of the grating pattern of the optical output portion 3 differ from each other.

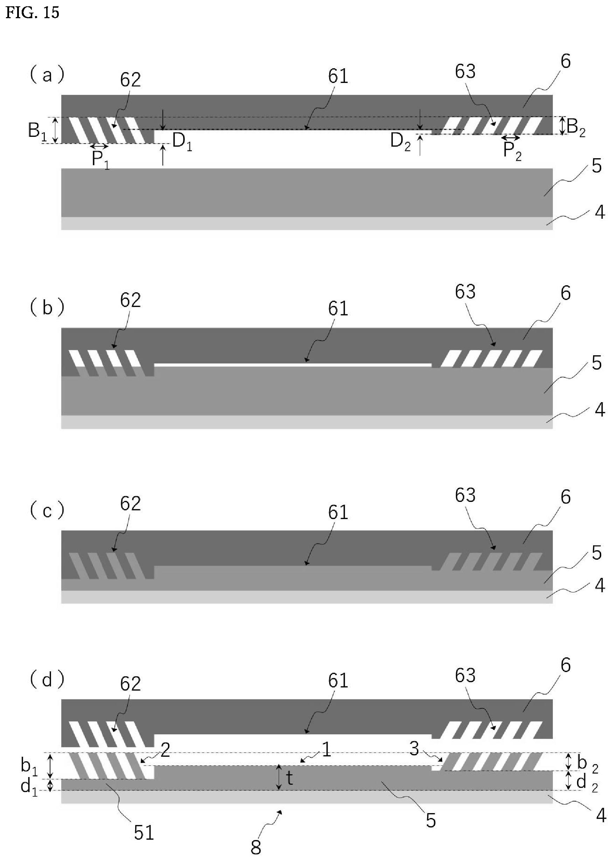

Moreover, FIG. 15 is a schematic cross-sectional view illustrating a manufacturing process of the optical waveguide in which, although respective positions of the bottom of the optical-input-portion pattern 62 and that of the optical-output-portion pattern 63 relative to the flat surface of the optical-transmit-portion pattern 61 of the optical waveguide mold 6 are aligned ($B_1 - D_1 = B_2 - D_2$), respective positions of the vertex of the optical-input-portion pattern 62 of the optical waveguide mold 6 and that of the optical-output-portion pattern 63 thereof differ from each other.

In this case, as for the manufactured optical waveguide, as illustrated in FIG. 15, part (d), although respective positions of the vertex of the grating pattern of the optical input portion 2 and that of the optical output portion 3 are consistent ($b_1 + = b_2 + d_2$), respective thicknesses of the residual film of the grating pattern of optical input portion 2 and that of the optical output portion 3 differ from each other.

Furthermore, when satisfying:

$$D_1 = B_1 \times (1 - FF_1);$$

and

$$D_2 = B_2 \times (1 - FF_2),$$

the optical waveguide mold 6 hardly causes the movement of the resin 5 in the horizontal direction, thus preferable.

In this case, the manufactured optical waveguide has the thickness t of the resin 5 of the optical transmit portion 1 which satisfies the following equation:

$$t = d_1 + b_1 \times ff_1 = d_2 + b_2 \times ff_2 = d_3 + b_3 \times ff_3.$$

Moreover, it is preferable that the thicknesses and $d_2$ of the grating pattern of the optical input portion 2 and of the optical output portion 3 should be smaller than or equal to 100 nm since the diffraction efficiency at the wide-angle side improves. In this case, the residual film 51 means, for each of the grating pattern of the optical input portion 2 formed by the optical-input-portion pattern 62, and of the grating pattern of the optical output portion 3 formed by the optical-output-portion pattern 63, the portion where the resin is the thinnest. It is preferable that either one of, preferably, both of the thicknesses and $d_2$ should be smaller than or equal to 100 nm, more preferably, smaller than or equal to 30 nm.

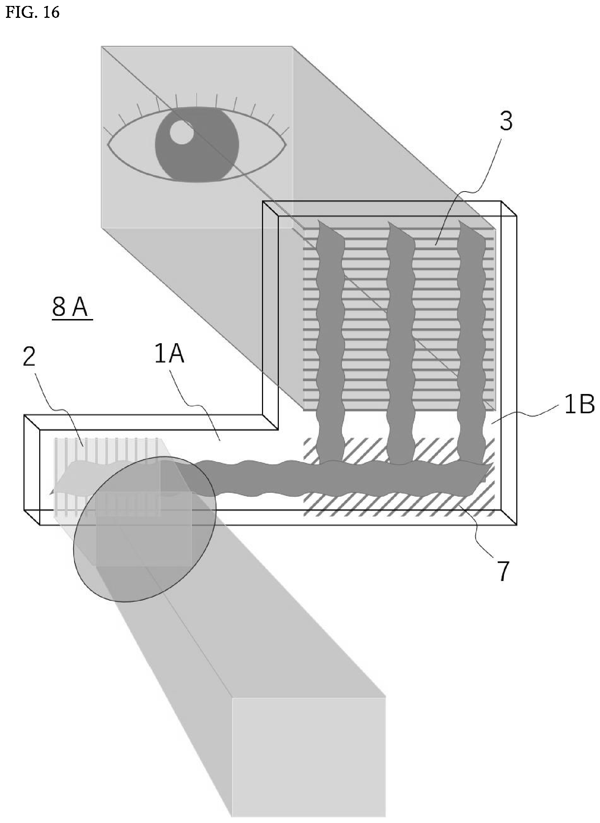

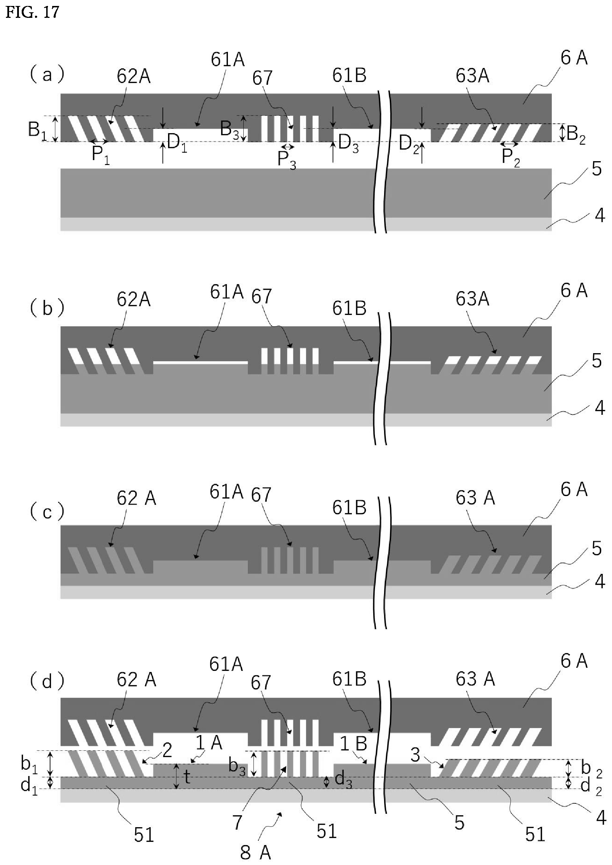

Furthermore, as illustrated in FIG. 16, the optical waveguide may include an optical enlarging portion 7 to enlarge exit pupil. In this case, as illustrated in FIG. 17, part (d), an optical waveguide 8A is formed of the transparent substrate 4, and of the resin 5 that is formed on the surface of the transparent substrate 4, and mainly includes a first optical transmit portion 1A, a second optical transmit portion 1B, the optical input portion 2, the optical enlarging portion 7, and the optical output portion 3.

The first optical transmit portion 1A and the second optical transmit portion 1B are each formed of the transparent substrate 4 and of the flat resin 5 that is formed on the surface of the transparent substrate 4, and are each to transmit light. Incident light from the optical input portion 2 is transmitted to the optical enlarging portion 7 while being totally reflected in the first optical transmit portion 1A. Moreover, incident light from the optical enlarging portion 7 is transmitted while being totally reflected in the second optical transmit portion 1B, and is output from optical output portion 3.

The optical input portion 2 is formed of the resin 5 that is formed as the grating pattern on the surface of the transparent substrate 4, and is to cause the light to enter the first optical transmit portion 1A. The shape of the grating pattern is not limited to any particular shape as far as it can cause the light to enter the first optical transmit portion 1A. For example, it may be a pattern which can cause the light to be diffracted so as to travel in the first optical transmit portion 1A while being totally reflected, and may be a line-and-space shape having inclined convexities arranged periodically.

The optical output portion 3 is formed of the resin 5 that is formed as the grating pattern on the surface of transparent substrate 4, and is to cause the light to be output from the second optical transmit portion 1B. The shape of the grating pattern is not limited to any particular shape as far as it can cause the light to be output from the second optical transmit portion 1B, but for example, it may be a pattern which can cause the light to be diffracted so as to be output from the transparent substrate 4 to the exterior, and may be a line-and-space shape having the inclined convexities arranged periodically.

The optical enlarging portion 7 is placed between the first optical transmit portion 1A and the second optical transmit portion 1B, is formed of the resin 5 that is formed as a pattern for enlarging on the surface of the transparent substrate 4, and is to control the incident light from the first optical transmit portion 1A and to output such light to the second transmit portion 1B so as to enlarge exit pupil. The pattern for enlarging is not limited to any particular shape as far as it can control the incident light from the first transmit portion 1A, and output such light to the second transmit portion 1B so as to enlarge exit pupil. For example, it may be a grating pattern which can duplicate the incident light from the first transmit portion 1A, can enlarge exit pupil, and may be in a line-and-space shape having convexities arranged periodically. In this case, the pitch of the convexities of the pattern for enlarging may be $1/\sqrt{2}$ times as that of the grating pattern of the optical input portion 2 and as that of the optical output portion 3.

The transparent substrate 4 is a base to form, on the resin 5, the flat portion of the first optical transmit portion 1A and that of the second optical transmit portion 1B, and the patterns of the optical input portion 2 and of the optical output portion 3. Moreover, it is to transmit the incident light from the optical input portion 2 to the optical output portion 3. Any material is applicable as far as it can transmit light from the optical input portion 2 to the optical output portion 3, and for example, a glass is applicable. Furthermore, in view of the above-described simulation results, it is preferable that the refractive index of the transparent substrate 4 should be greater than or equal to 1.8, more preferably, greater than or equal to 1.9, and further preferably, greater than or equal to 2.0.

The resin 5 is to form the patterns of the optical input portion 2, the optical output portion 3, the optical enlarging portion 7, and, the first optical transmit portion 1A and the second optical transmit portion 1B. Any material is applicable as far as it can form the optical transmit portion 1, and, the pattern of the optical input portion 2 and that of the optical output portion 3. Moreover, in view of the above-described simulation results, it is preferable that the refractive index of the transparent substrate 4 and that of the resin 5 should be greater than or equal to 1.8, more preferably, greater than or equal to 1.9, further preferably, greater than or equal to 1.95.

An optical waveguide mold 6A to manufacture the optical waveguide that includes such an optical enlarging portion 7 mainly includes, as illustrated in FIG. 17, part (a), a first-optical-transmit-portion pattern 61A, a second-optical-transmit-portion pattern 61B, an optical-input-portion pattern 62A, an optical-output-portion pattern 63A, and an optical-enlarging-portion pattern 67. The material of the optical waveguide mold 6A is not limited to any particular material as far as it is applicable for imprinting, but for example, a well-known material like a glass is applicable.

The first-optical-transmit-portion pattern 61A is a flat pattern to form the flat portion of the first optical transmit portion 1A on the resin 5. Moreover, The second-optical-transmit-portion pattern 61B is a flat pattern to form the flat portion of the second optical transmit portion 1B on the resin 5.

The optical-input-portion pattern 62A is to form the optical input portion 2 on the resin 5. The optical-input-portion pattern 62 is not limited to any particular pattern as far as it can form the optical input portion 2 on the resin 5, but for example, may be an inverted pattern of the above-described grating pattern of the optical input portion 2.

The optical-output-portion pattern 63A is to form the optical output portion 3 on the resin 5. The optical-output-portion pattern 63 is not limited to any particular pattern as far as it can form the optical output portion 3 on the resin 5, but for example, may be an inverted pattern of the above-described grating pattern of the optical output portion 3.

The optical-enlarging-portion pattern 67 is to form the optical enlarging portion 7 on the resin 5. The optical-enlarging-portion pattern 67 is not limited to any particular pattern as far as it can form the optical enlarging portion 7 on the resin 5, but for example, may be an inverted pattern of the above-described pattern for enlarging of the enlarging portion 3.

In order to suppress the movement of the resin 5 in the horizontal direction when the resin 5 is pressurized by the optical waveguide mold 6A, it is appropriate that the voids (recesses) of the optical-input-portion pattern 62A and of the optical-enlarging-portion pattern 67, the voids of the optical-input-portion pattern 62A and of the first-optical-transmit-portion pattern 61A adjacent to the optical-enlarging-portion pattern 67, and the voids of the optical-output-portion pattern 63A and of the second optical-transmit-portion pattern 61B adjacent to the optical-enlarging-portion pattern 67 should be balanced in volume per a unit space. More specifically, when it is defined that the depth of the recess of the optical-input-portion pattern 62A is $B_1$, the fill factor of the convexity thereof is $FF_1$, the depth of the recess of the optical-output-portion pattern 63A is $B_2$, the fill factor of the convexity thereof is $FF_2$, the depth of the recess of the optical-enlarging-portion pattern 67 is $B_3$, and the fill factor of the convexity thereof is $FF_3$, it is appropriate that a difference $D_1$ between the height of the optical-input-portion pattern 62A and the height of the first-optical-transmit-portion pattern 61A, a difference $D_2$ between the height of the optical-output-portion pattern 63A and the height of the second-optical-transmit-portion pattern 61B, and a difference $D_3$ between the height of optical-enlarging-portion pattern 67 and the height of the first-optical-transmit-portion pattern 61A or of the second-optical-transmit-portion pattern 61B should satisfy the following equations:

$$0.9 \times B_1 \times (1 - FF_1) \leq D_1 \leq 1.1 \times B_1 \times (1 - FF_1);$$

$$0.9 \times B_2 \times (1 - FF_2) \leq D_2 \leq 1.1 \times B_2 \times (1 - FF_2);$$

and

$$0.9 \times B_3 \times (1 - FF_3) \leq D_3 \leq 1.1 \times B_3 \times (1 - FF_3).$$

Note that, although an error up to $\pm 10$ % is permitted in the equations, the smaller error is preferable that is smaller than or equal to 5 %, more preferably, smaller than or equal to 3 %.

In this case, as for an optical waveguide 8A manufactured by the optical waveguide mold 6A, when it is defined that the height of the convexity of the grating pattern of the optical input portion 2 is $b_1$, the fill factor of the convexity thereof is $ff_1$, the thickness of the residual film thereof is $d_1$, the height of the convexity of the grating pattern of the optical output portion is $b_2$, the fill factor of the convexity thereof is $ff_2$, the thickness of the residual film thereof is $d_2$, the height of the convexity of the pattern for enlarging of the optical enlarging portion 7 is $b_3$, the fill factor of the convexity thereof is $ff_3$, and the thickness of the residual film thereof is $d_3$, a thickness t of the resin at the first optical transmit portion 1A and at the second optical transmit portion 1B satisfies the following equations:

$$0.9 \times (d_1 + b_1 \times ff_1) \leq t \leq 1.1 \times (d_1 + b_1 \times ff_1);$$

$$0.9 \times (d_2 + b_2 \times ff_2) \leq t \leq 1.1 \times (d_2 + b_2 \times ff_2);$$

and

$$0.9 \times (d_3 + b_3 \times ff_3) \leq t \leq 1.1 \times (d_3 + b_3 \times ff_3).$$

Moreover, as illustrated in FIG. 17, part (a), the optical waveguide mold 6A may be formed in such a way that, although respective positions of the vertex of the optical-input-portion pattern 62A, that of the optical-output-portion pattern 63A and that of the optical-enlarging-portion pattern 67 are aligned ($D_1 = D_2 = D_3$) relative to the flat surface of the first-optical-transmit-portion pattern 61A and that of the second-optical-transmit-portion pattern 61B, respective positions of the bottom of the optical-input-portion pattern 62A of the optical waveguide mold 6A, that of optical-output-portion pattern 63A thereof, and that of the optical-enlarging-portion pattern 67 differ from each other. FIG. 17 is a schematic cross-sectional view illustrating a manufacturing process of the optical waveguide when imprint molding is carried out using such an optical waveguide mold 6A.

According to the manufactured optical waveguide 8A, in this case, as illustrated in FIG. 17, part (d), although respective thicknesses of the residual film of the pattern of the optical input portion 2, that of the optical output portion 3, and that of the optical enlarging portion 7 are consistent ($d_1 = d_2 = d_3$), the height $b_1$ of the convexity of the grating pattern of the optical input portion 2, the height $b_2$ of the convexity of the grating pattern of the optical output portion 3, and the height $b_3$ of the convexity of the pattern of optical enlarging portion 7 differ from each other.

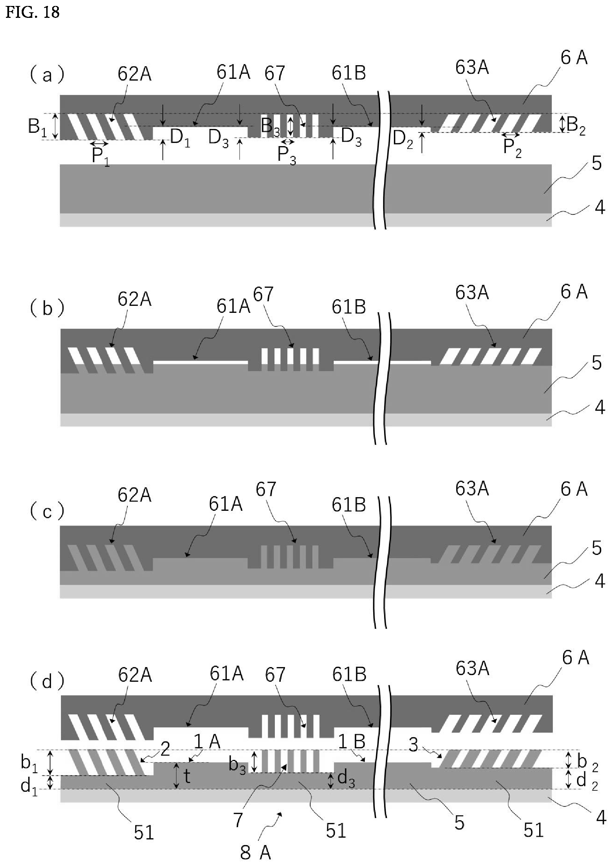

Moreover, as illustrated in FIG. 18, part (a), the optical waveguide mold 6A may be formed in such a way that, although respective position of the bottom of the optical-input-portion pattern 62A, that of the optical-output-portion pattern 63A and that of the optical-enlarging-portion pattern 67 are aligned ($B_1 - D_1 = B_2 - D_2 = B_3 - D_3$) relative to the flat surface of the first-optical-transmit-portion pattern 61A and that of the second-optical-transmit-portion pattern 61B, respective positions of the vertex of the optical-input-portion pattern 62A of the optical waveguide mold 6A, that of the optical-output-portion pattern 63A thereof, and that of the optical-enlarging-portion pattern 67 there differ from each other. FIG. 18 is a schematic cross-sectional view illustrating a manufacturing process of the optical waveguide when imprint molding is carried out using such an optical waveguide mold 6A.

In this case, as illustrated in FIG. 18, part (d), according to the manufactured optical waveguide 8A, although respective position of the vertex of the pattern of the optical input portion 2, that of the optical output portion 3, and that of the optical enlarging portion 7 are consistent ($b_1 + d_1 = b_2 + d_2 = b_3 + d_3$), respective thicknesses of the residual film of the pattern of the optical input portion 2, that of the optical output portion 3, and that of the optical enlarging portion 7 differ from each other.

Moreover, it is preferable that the optical waveguide mold 6A should satisfy the followings since the movement of the resin 5 in the horizontal direction most hardly occurs when the followings are satisfied:

$$D_1 = B_1 \times (1 - FF_1);$$

$$D_2 = B_2 \times (1 - FF_2);$$

and

$$D_3 = B_3 \times (1 - FF_3).$$

According to the manufactured optical waveguide, in this case, the thickness t of the resin 5 of the first optical transmit portion 1A and that of the second optical transmit portion 1B satisfy the following equation:

$$t = d_1 + b_1 \times ff_1 = d_2 + b_2 \times ff_2 = d_3 + b_3 \times ff_3.$$

Furthermore, it is preferable that the respective thicknesses $d_1$, $d_2$ and $d_3$ of the residual film 51 of the grating pattern of the optical input portion 2 and that of the optical output portion 3, and that of the pattern for enlarging of the optical enlarging portion 7 should be smaller than equal to 100 nm since the diffraction efficiency at the wide-angle side improves. In this case, the residual film 51 means, for each of the grating pattern of the optical input portion 2 formed by the optical-input-portion pattern 62A, the grating pattern of optical output portion 3 formed by the optical-output-portion pattern 63A, and the pattern for enlarging of the optical enlarging portion 7 formed by the optical-enlarging-portion pattern 67, the portion where the resin is the thinnest. It is preferable that greater than or equal to at least any one of the thicknesses $d_1$, $d_2$, and $d_3$, more preferably, all of those should be smaller than or equal to 100 nm, and further preferably, smaller than or equal to 30 nm.

REFERENCE SIGNS LIST

| 1 | Optical transmit portion |
| 1A | First optical transmit portion |
| 1B | Second optical transmit portion |
| 2 | Optical input portion |
| 2A | Optical input portion |
| 3 | Optical output portion |
| 3A | Optical output portion |
| 4 | Transparent substrate |
| 5 | Resin |
| 6 | Optical waveguide mold |
| 6A | Optical waveguide mold |
| 7 | Optical enlarging portion |
| 8 | Optical waveguide |
| 8A | Optical waveguide |
| 9 | Void |
| 51 | Residual film |
| 61 | Optical-transmit-portion pattern |
| 61A | First-optical-transmit-portion pattern |
| 61B | Second-optical-transmit-portion pattern |
| 62 | Optical-input-portion pattern |
| 62A | Optical-input-portion pattern |
| 63 | Optical-output-portion pattern |
| 63A | Optical-output-portion pattern |
| 67 | Optical-enlarging-portion pattern |

**Claims**

1. An optical waveguide mold for manufacturing an optical waveguide which is formed of a transparent substrate and of a resin formed on a surface of the transparent substrate, and which comprises:

   an optical transmit portion that is to transmit light;
   an optical input portion that is to cause the light to enter the optical transmit portion; and
   an optical output portion that is to cause the light to be output from the optical transmit portion,
   the optical waveguide mold comprising:

   a flat optical-transmit-portion pattern to form the optical transmit portion on the resin; and
   at least either one of or both of an optical-input-portion pattern to form the optical input portion on the resin and an optical-output-portion pattern to form the optical output portion on the resin,
   wherein when it is defined that a depth of a recess of the optical-input-portion pattern or of the optical-output-portion pattern is B, a fill factor of a convexity thereof is FF, and a difference between a height of the optical-input-portion pattern or of the optical-output-portion pattern and a height of the optical-transmit-portion pattern is D, the optical waveguide mold satisfies a following equation:

   $$0.9 \times B \times (1 - FF) \leq D \leq 1.1 \times B \times (1 - FF).$$

2. The optical waveguide mold according to claim 1, satisfying $D = B \times (1 - FF)$.

3. An optical waveguide mold for manufacturing an optical waveguide which is formed of a transparent substrate and of a resin formed on a surface of the transparent substrate, and which comprises:

   an optical transmit portion that is to transmit light;
   an optical input portion that is to cause the light to enter the optical transmit portion; and
   an optical output portion that is to cause the light to be output from the optical transmit portion,
   the optical waveguide mold comprising:

   a flat optical-transmit-portion pattern to form the optical transmit portion on the resin;
   an optical-input-portion pattern to form the optical input portion on the resin; and
   an optical-output-portion pattern to form the optical output portion on the resin,
   wherein when it is defined that a depth of a recess of the optical-input-portion pattern is $B_1$, a fill factor of a convexity thereof is $FF_1$, a depth of a recess of the optical-output-portion pattern is $B_2$, a fill factor of a convexity thereof is $FF_2$, a difference between a height of the optical-input-portion pattern and a height of the optical-transmit-portion pattern is $D_1$, and a difference between a height of the optical-output-portion pattern and the height of the optical-transmit-portion pattern is $D_2$, the optical waveguide mold satisfy following equations:

   $$0.9 \times B_1 \times (1 - FF_1) \leq D_1 \leq 1.1 \times B_1 \times (1 - FF_1);$$

   and

   $$0.9 \times B_2 \times (1 - FF_2) \leq D_2 \leq 1.1 \times B2 \times (1 - FF_2).$$

4. The optical waveguide mold according to claim 3, satisfying $D_1 = D_2$.

5. The optical waveguide mold according to claim 3, satisfying $B_1 - D_1 = B_2 - D_2$.

6. The optical waveguide mold according to claim 3, satisfying:

   $$D_1 = B_1 \times (1 - FF_1);$$

   and

$$D_2 = B_2 \times (1 - FF_2).$$

7. An optical waveguide mold for manufacturing an optical waveguide which is formed of a transparent substrate and of a resin formed on a surface of the transparent substrate, and which comprises:

first and second optical transmit portion each being to transmit light;
an optical input portion that is to cause the light to enter the first optical transmit portion;
an optical enlarging portion which is placed between the first optical transmit portion and the second optical transmit portion, and which controls the incident light from the first optical transmit portion and outputs to the second optical transmit portion so as to enlarge exit pupil; and
an optical output portion that is to cause the light to be output from the second optical transmit portion,
the optical waveguide mold comprising:

a flat first-optical-transmit-portion pattern to form the first optical transmit portion on the resin;
a flat second-optical-transmit-portion pattern to form the second optical transmit portion on the resin;
an optical-input-portion pattern to form the optical input portion on the resin;
an optical-output-portion pattern to form the optical output portion on the resin; and
an optical-enlarging-portion pattern to form the optical enlarging portion on the resin,
wherein when it is defined that a depth of a recess of the optical-input-portion pattern is $B_1$, a fill factor of a convexity thereof is $FF_1$, a depth of a recess of the optical-output-portion pattern is $B_2$, a fill factor of a convexity thereof is $FF_2$, a depth of a recess of the optical-enlarging-portion pattern is $B_3$, and a fill factor of a convexity thereof is $FF_3$, a difference $D_1$ between a height of the optical-input-portion pattern and a height of the first-optical-transmit-portion pattern, a difference $D_2$ between a height of the optical-output-portion pattern and a height of the second-optical-transmit-portion pattern, and a difference $D_3$ between a height of the optical-input-portion pattern and the height of the first-optical-transmit-portion pattern or of the second-optical-transmit-portion pattern satisfy following equations:

$$0.9 \times B_1 \times (1 - FF_1) \le D_1 \le 1.1 \times B_1 \times (1 - FF_1);$$

$$0.9 \times B_2 \times (1 - FF_2) \le D_2 \le 1.1 \times B_2 \times (1 - FF_2);$$

and

$$0.9 \times B_3 \times (1 - FF_3) \le D_3 \le 1.1 \times B_3 \times (1 - FF_3).$$

8. The optical waveguide mold according to claim 7, satisfying $D_1 = D_2 = D_3$.

9. The optical waveguide mold according to claim 7, satisfying $B_1 - D_1 = B_2 - D_2 = B_3 - D_3$.

10. The optical waveguide mold according to claim 7, satisfying:

$$D_1 = B_1 \times (1 - FF_1);$$

$$D_2 = B_2 \times (1 - FF_2);$$

and

$$D_3 = B_3 \times (1 - FF_3).$$

11. A method for manufacturing an optical waveguide, comprising:
carrying out imprint molding using the optical waveguide mold according to any one of claims 1 to 10.

12. The optical waveguide manufacturing method according to claim 11, wherein a refractive index of the resin is greater than or equal to 1.8.

13. The optical waveguide manufacturing method according to claim 11, wherein the imprint molding is carried out in such a way that a thickness of a residual film of the resin formed by at least any one of the optical-input-portion pattern, the optical-output-portion pattern and the optical-enlarging-portion pattern becomes smaller than or equal to 100 nm.

14. An optical waveguide that is formed of a transparent substrate, and of a resin formed on a surface of the transparent substrate, the optical waveguide comprising:

an optical transmit portion which is formed of the transparent substrate and of the flat resin formed on the surface of the transparent substrate, and which is to transmit light;
an optical input portion which is formed of the resin formed as a grating pattern on the surface of the transparent substrate, and which is to cause the light to enter the optical transmit portion; and
an optical output portion which is formed of the resin formed as a grating pattern on the surface of the transparent substrate, and which is to cause the light to be output from the optical transmit portion,
wherein when it is defined that a height of a convexity of the grating pattern of the optical input portion is $b_1$, a fill factor of the convexity thereof is $ff_1$, a thickness of a residual film thereof is $d_1$, a height of a convexity of the grating pattern of the optical output portion is $b_2$, a fill factor of the convexity thereof is $ff_2$, and a thickness of a residual film thereof is $d_2$, a thickness t of the resin at the optical transmit portion satisfy the following equations:

$$0.9 \times (d_1 + b_1 \times ff_1) \leq t \leq 1.1 \times (d_1 + b_1 \times ff_1);$$

and

$$0.9 \times (d_2 + b_2 \times ff_2) \leq t \leq 1.1 \times (d_2 + b_2 \times ff_2).$$

15. The optical waveguide according to claim 14, satisfying $= d_2$.

16. The optical waveguide according to claim 14, satisfying $b_1 + = b_2 + d_2$.

17. The optical waveguide according to claim 14, satisfying $t = d_1 + b_1 \times ff_1 = d_2 + b_2 \times ff_2$.

18. An optical waveguide that is formed of a transparent substrate, and of a resin formed on a surface of the transparent substrate, the optical waveguide comprising:

first and second optical transmit portions each formed of the transparent substrate and of the flat resin formed on the surface of the transparent substrate, and each being to transmit light;
an optical input portion which is formed of the resin that is formed as a grating pattern on the surface of the transparent substrate, and which is to cause the light to enter the first optical transmit portion;
an optical enlarging portion which is placed between the first optical transmit portion and the second optical transmit portion, is formed of the resin that is formed as a pattern for enlarging on the surface of the transparent substrate, and controls the incident light from the first optical transmit portion and outputs to the second optical transmit portion so as to enlarge exit pupil; and
an optical output portion which is formed of the resin that is formed as a grating pattern on the surface of the transparent substrate, and which is to cause the light to be output from the second optical transmit portion,
wherein when it is defined that a height of a convexity of the grating pattern of the optical input portion is $b_1$, a fill factor of the convexity thereof is $ff_1$, a thickness of a residual film thereof is $d_1$, a height of a convexity of the grating pattern of the optical output portion is $b_2$, a fill factor of the convexity thereof is $ff_2$, a thickness of a residual film thereof is $d_2$, a height of a convexity of the pattern for enlarging of the optical enlarging portion is $b_3$, a fill factor of the convexity thereof is $ff_3$, and a thickness of a residual film thereof is $d_3$, a thickness t of the resin at the first optical transmit portion and at the second optical transmit portion satisfies the following equations:

$$0.9 \times (d_1 + b_1 \times ff_1) \leq t \leq 1.1 \times (d_1 + b_1 \times ff_1);$$

$$0.9 \times (d_2 + b_2 \times ff_2) \leq t \leq 1.1 \times (d_2 + b_2 \times ff_2);$$

and

$$0.9 \times (d_3+b_3 \times ff_3) \leq t \leq 1.1 \times (d_3+b_3 \times ff_3).$$

**19.** The optical waveguide according to claim 18, satisfying $= d_2 = d_3$.

**20.** The optical waveguide according to claim 18, satisfying $b_1 + = b_2 + d_2 = b_3 + d_3$.

**21.** The optical waveguide according to claim 18, satisfying $t = d_1+b_1 \times ff_1 = d_2+b_2 \times ff_2 = d_3+b_3 \times ff_3$.

**22.** The optical waveguide according to any one of claims 14 to 21, wherein a refractive index of the resin is greater than or equal to 1.8.

**23.** The optical waveguide according to any one of claims 14 to 21, wherein a thickness of a residual film of at least any one of the grating patterns of the optical input portion, of the optical output portion, and a pattern for enlarging of the optical enlarging portion is smaller than or equal to 100 nm.

FIG. 1

FIG. 2

FIG. 3

（a）

（1）

5
4
N:2.0

（4）

5
N:1.9
51
N:2.0
t=0.1μm
4

（2）

5
N:1.9
N:2.0
t=0μm
4

（5）

5
N:1.9
51
N:2.0
t=0.3μm
4

（3）

5
N:1.9
51
N:2.0
t=0.03μm
4

（6）

5
N:1.9
4

（b）

FIG. 4

FIG. 5

FIG. 6

FIG. 7

（a）

62(63)　　　6　　　　61

（b）

62(63)　　　6　　　61　　5　　4

（c）

62(63)　　　6　　　61　　5　　4

（d）

62(63)　　　6　　　61

2 (3)　　1　　5

51　　4

FIG. 8

FIG. 9

（a）

（b）

（c）

FIG. 10

FIG. 11

FIG. 12

FIG. 13

FIG. 14

FIG. 15

FIG. 16

FIG. 17

FIG. 18

# INTERNATIONAL SEARCH REPORT

| International application No. |
|---|
| **PCT/JP2024/029129** |

**A.    CLASSIFICATION OF SUBJECT MATTER**

*B29C 59/02*(2006.01)i; *B29C 33/42*(2006.01)i; *G02B 5/18*(2006.01)i; *G02B 6/13*(2006.01)i; *G02B 6/124*(2006.01)i
FI:    B29C59/02 B; B29C33/42; G02B5/18; G02B6/124; G02B6/13

According to International Patent Classification (IPC) or to both national classification and IPC

**B.    FIELDS SEARCHED**

Minimum documentation searched (classification system followed by classification symbols)

B29C59/02; B29C33/42; G02B5/18; G02B6/13; G02B6/124

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2021-178405 A (AGC INC.) 18 November 2021 (2021-11-18)<br>paragraphs [0002], [0025]-[0029], fig. 1-2 | 1-23 |
| A | JP 2008-012844 A (HITACHI HIGH-TECHNOLOGIES CORPORATION) 24 January 2008 (2008-01-24)<br>paragraphs [0088]-[0092], fig. 12-13 | 1-23 |
| A | JP 2017-151187 A (TOPPAN PRINTING CO., LTD.) 31 August 2017 (2017-08-31)<br>fig. 1, 5-6 | 1-23 |
| A | JP 2020-046531 A (ASAHI KASEI EMD CORPORATION) 26 March 2020 (2020-03-26)<br>fig. 1 | 1-23 |
| A | JP 2006-184801 A (BRIDGESTONE CORPORATION) 13 July 2006 (2006-07-13)<br>fig. 3 | 1-23 |
| A | JP 2010-079041 A (TOHOKU UNIVERSITY) 08 April 2010 (2010-04-08)<br>fig. 4, 10 | 1-23 |

☑ Further documents are listed in the continuation of Box C.       ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 September 2024** | **01 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
|---|
| **PCT/JP2024/029129** |

**C.    DOCUMENTS CONSIDERED TO BE RELEVANT**

| Category* | Citation of document, with indication, where appropriate, of the relevant passages | Relevant to claim No. |
|---|---|---|
| A | WO 2008/090945 A1 (SUMITOMO ELECTRIC FINE POLYMER INC.) 31 July 2008 (2008-07-31)<br>fig. 7-10 | 1-23 |
| A | US 2021/0268756 A1 (MAGIC LEAP, INC.) 02 September 2021 (2021-09-02)<br>fig. 9-12 | 1-23 |
| A | US 2023/0035735 A1 (TAIWAN SEMICONDUCTOR MANUFACTURING COMPANY, LTD.) 02 February 2023 (2023-02-02)<br>fig. 1-2 | 1-23 |

Form PCT/ISA/210 (second sheet) (July 2022)

**INTERNATIONAL SEARCH REPORT**
**Information on patent family members**

International application No.

**PCT/JP2024/029129**

| Patent document cited in search report | | | Publication date (day/month/year) | Patent family member(s) | | | Publication date (day/month/year) |
|---|---|---|---|---|---|---|---|
| JP | 2021-178405 | A | 18 November 2021 | (Family: none) | | | |
| JP | 2008-012844 | A | 24 January 2008 | US paragraphs [0126]-[0134], fig. 12-13 | 2012/0074615 | A1 | |
| JP | 2017-151187 | A | 31 August 2017 | (Family: none) | | | |
| JP | 2020-046531 | A | 26 March 2020 | (Family: none) | | | |
| JP | 2006-184801 | A | 13 July 2006 | (Family: none) | | | |
| JP | 2010-079041 | A | 08 April 2010 | (Family: none) | | | |
| WO | 2008/090945 | A1 | 31 July 2008 | US fig. 7-10 JP EP KR CN | 2010/0165471 8-90945 2107398 10-2009-0104013 101589317 | A1 A1 A1 A A | |
| US | 2021/0268756 | A1 | 02 September 2021 | JP WO CN | 2023-516594 2021/174062 115190837 | A A1 A | |
| US | 2023/0035735 | A1 | 02 February 2023 | (Family: none) | | | |

Form PCT/ISA/210 (patent family annex) (July 2022)

REFERENCES CITED IN THE DESCRIPTION

**Patent documents cited in the description**

• JP 2016207717 A